# EUROPEAN PATENT APPLICATION

(11) **EP 2 698 806 A1**
(43) Date of publication of application: **19.02.2014**
(21) Application number: 12180225.0
(22) Date of filing: 13.08.2012
(51) Int. Cl.: H01L 21/225, H01L 21/324, H01L 31/18

(54) **Method for producing a dopant profile in a semiconductor substrate**

(71) Applicant: Fraunhofer Gesellschaft zur Förderung der angewandten Forschung e.V., 80686 München (DE)
(72) Inventor: Manole, Mihail, 63796 Kahl am Main (DE); Vaas, Knut, 63755 Alzenau (DE)
(74) Representative: Stoffregen, Hans-Herbert

(57) **Abstract**

The invention relates to a method for producing a dopant profile in an alkaline textured mono-crystalline silicon based semiconductor substrate of a solar cell, comprising: applying a liquid dopant source onto the textured surface of the semiconductor substrate, and drying the dopant source while precipitates are generated simultaneously, performing at least one heat treatment step for diffusing dopant atoms into the semiconductor substrate. To develop the aforementioned method such that it is possible to set the dopant concentration in the surface region such that no contact problems occur when applying a front contact. For solving this object, it is basically provided that the drying of the dopant source is followed by two temperature treatment steps, with the semiconductor substrate in a first temperature treatment step being heated up to a temperature T₁ and being held over a time t₁ at the temperature T₁ and being subsequently cooled down to a second temperature T₂, and in a second temperature treatment step being held over a time t₂ at the temperature T2; the temperature difference ΔT between T₁ and T₂ is 50 °C ≤ ΔT ≤ 100 °C and t₁ << t₂.

## Description

The invention relates to a method for producing a dopant profile in an alkaline textured mono-crystalline silicon based semiconductor substrate of a solar cell, comprising:
- applying a liquid dopant source onto the textured surface of the semiconductor substrate,
- drying the dopant source while precipitates are generated simultaneously,
- performing at least one heat treatment step for diffusing dopant atoms into the semiconductor substrate.

Particularly the invention relates to the production of alkaline textured mono-crystalline solar cells which are produced by means of liquid phosphorous source diffusion.

At present phosphorous diffusion continues to play a crucial role in the crystalline solar cells production. There are different industrial methods to produce high quality emitters. Usually an industrial diffusion process contains two steps:
a) Deposition of the phosphorous source on the Si surface with or without subsequent drying step.
b) Drive-in process -it means a thermal process where the phosphorous atoms diffuse from the surface into the bulk of the Si wafer and a p-n junction is produced. The temperature T, time t and the ambiance of the drive-in process are very important for the cell performances.

A traditional diffusion method is the diffusion from POCL3 source produced in an opened or closed tube system. The phosphorous source is deposited from the gas phase of POCL3 vapours. This method permits formation of high-quality emitters on all kinds of Si surfaces: alkaline or acidic textured and polished surfaces as well. The deposited P-source- PSG (Phosphorous Silicon Glass) is homogeneously grown on the Si surface. One of POCL3 diffusion conditions is the arrangement of the Si wafers perpendicularly to the coming gas. To hold the wafers during the process vertically in the tube and perpendicularly to the coming gas flux a quartz boat with vertical slots is used. The deposition and the drive-in take place in the same tube at the same or different temperature plateaus. During the diffusion the wafers are kept without movement and the temperature is changed with the time. The biggest disadvantage of the POCL3 method is a large amount of broken wafers during the loading of the boat with wafers- it means high breakage percentage. The POCL3 method is used mainly in the" batch" cell process production.

In case of "in-line" diffusion the silicon wafers move on the belt along the segments of a thermal oven with a defined speed. Wafers are placed horizontally, directly on the belt without using any kind of boats. In-line diffusion method is characterized by a high throughput of the processed wafers. The phosphorous source deposition methods such as Spin-on liquids, Spray-on liquids, Deposition of the H₃PO₄ mist on the silicon surface, a simple immersion of Si wafer in the liquid H₃PO₄ etc, are used in this case. Practically all of these methods use the deposition of the phosphorous source from the liquids. The deposited phosphorous liquid source as a film on the emitter surface is previously dried in a fast process oven (deposition oven) and then is sent on the belt of the drive-in oven. The drying process is characterized by T₀ - drying plateau temperature and t₀ - drying duration. The length of the drive-in oven and the speed of the belt have a strong impact on the temperature profile of diffusion process and on phosphorous concentration profile of the emitter.

The general trend in industrial in-line drive-in process is to have a cost-effective process with a short duration and a high throughput. But the duration of the process has a large meaning for the emitter quality.

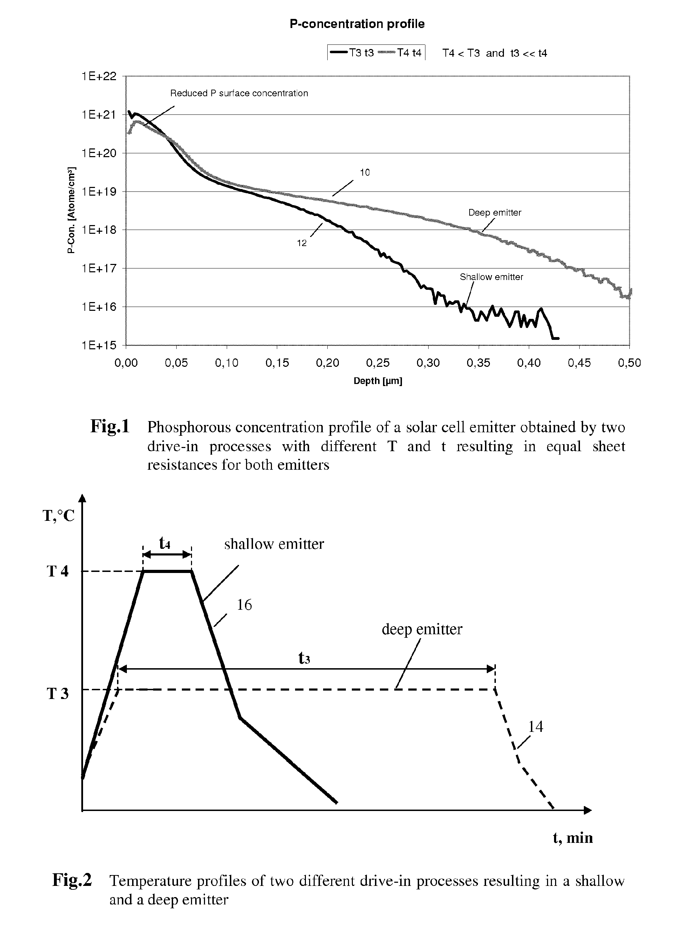

In different drive-in variants it is requested to decrease the P-surface concentration and to increase the emitter depth without changing the sheet resistance value. Komatsu et al ("Innovative diffusion processes for improved efficiency on industrial solar cells by doping profile manipulations", 24th European Photovoltaic Solar Energy Conference and Exhibition, 21-25 September 2009, Hamburg) has shown a method of multi-plateau drive-in process to minimize the P-surface concentration without changing the process duration. The temperatures increase from plateau to plateau. Increasing the temperature for different subsequent plateaus they were able to improve the Voc and the efficiency of produced multi-crystalline cells. Better results are obtained if the temperature of the whole drive in process is decreased. It is known that a long drive-in process, performed at low temperature has a beneficial impact on the cell parameters. In Fig.1 it is shown a typical behaviour of the phosphorous concentration profile of an emitter diffused at different temperature T with different duration t, and having equal resulting sheet resistance. Temperature T₄ of a first drive-in process represented by graph 10 is higher than temperature T₃ of a second drive-in process represented by graph 12. Duration of the first drive-in process is t₄ << t₃ with t₃ the duration of the second drive-in process.

Temperature profiles of the both diffused emitters are present in Fig.2. Graph 14 corresponds to the first drive-in process according to graph 10 in Fig. 1 and the other graph 16 corresponds to the second drive-in process (graph 12 in Fig. 1). It is possible to see that the differences in the temperatures and process duration cause a difference in the emitter depth. The difference in the emitter depths is caused by two different diffusion mechanisms which occur at the emitter surface and emitter bulk. A. Benzen et al (Understanding phosphorous diffusion in silicon solar cells, 21-st European Solar Energy Conference, page 1388-1391) explain it as a complex interaction between the diffusing dopants and the point defects in the crystal, where the diffusion coefficients of the phosphorous atoms at the emitter surface and emitter bulk are not equal.

The P-concentration at the surface exceeds the limit of the solid solubility of P in silicon. This effect is characterised by P-Si cluster formation, where P is "captured" at the surface as precipitate in a new phase. Thus, the P-dopant at the surface requires a higher temperature T to be diffused into the bulk.

By decreasing the diffusion temperature and increasing the diffusion time it is possible to obtain deeper emitters changing slightly the P-profile near the surface and moving deeper the dopant atoms into the silicon bulk.

If the long drive-in process takes place in an oxidizing ambience (usually it is dry air) the surface P-concentration is reduced by taking a part of P in SiO₂ layer. In such a way a deep emitter with a reduced P-surface concentration is produced. In modem solar cell technologies as a method for front grid metallisation usually screen printing is used. It requires the deposition of Ag pastes on the emitter surface with a subsequent thermal drying and sintering. The emitter depth influences the recombination processes which can be induced by the metal particles after the sintering of the front side metal grid. During the sintering the metal particles diffuse into the emitter and form a low resistance ohmic metal-semiconductor junction. The deeper is emitter the lower is probability for the metal particles to reach the Space Charge Region and to induce recombination current. It must be also mentioned that the P-surface concentration influences the contact resistance of metal-semiconductor junction. The higher is the P-concentration the lower is the contact resistance. The effect of a deep emitter results in all cases in an improved Voc. In case of the absence of the high contact resistance effect, it results also in an improved FF. The reduced phosphorous surface concentration allows a better surface passivation of Si by SiNₓ which is deposited on the emitter surface as an antireflective coating. This effect brings an improved Voc too. And as a last reason the gettering of the metal impurities is stronger during a long time drive-in process.

The method which allows to increase the drive-in process duration t without decreasing the throughput of produced solar cell units was reported by Horzel et al (Horzel, Proc. 24th EU PVSEC, Sept. 2009, Hamburg, pp 1077 - 1081). The long drive-in method is cost effective and industrially acceptable.

WO-A-2010/066626 discloses a method for producing a dopant profile in a semiconductor substrate. This can be a monocrystalline or a polycrystalline silicon material. During a first step, a liquid dopant source is applied onto the substrate and dried subsequently. This results in a preliminary first dopant profile. Respective semiconductor substrates with the first dopant profile are placed on top of each other to form a stack which is then subjected to a heat treatment during which a second dopant profile is formed which, compared to the first dopant profile has a greater depth.

An example of the real parameters of the real cells which have been diffused at two different temperatures T₁, T₂ and durations t₁, t₂ (see Fig. 1, 2) is given in the Table 1

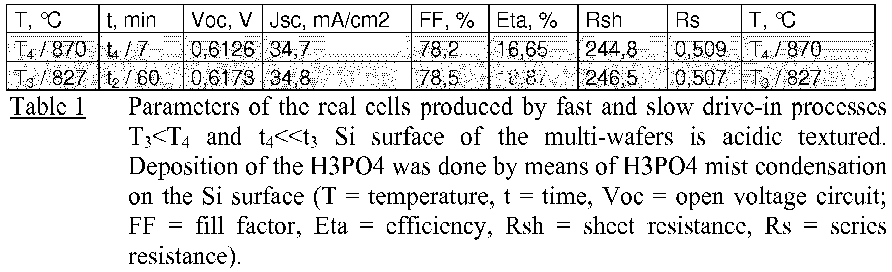

Table 1 shows an increased Voc in case of the slow drive-in process and as a result the efficiency Eta is improved about 0.2% absolute. As it was above mentioned texture of the wafers was done in an acidic chemical texturing solution on multicrystalline material. This type of texturing is characterized by a homogeneous deposition of the H₃PO₄ film on the silicon surface from the liquid source. It permits to obtain a homogeneously distributed emitter along the Si depth. Therefore there are no difficulties to contact such kind of the emitter and the FF of these cells stays at a high value.

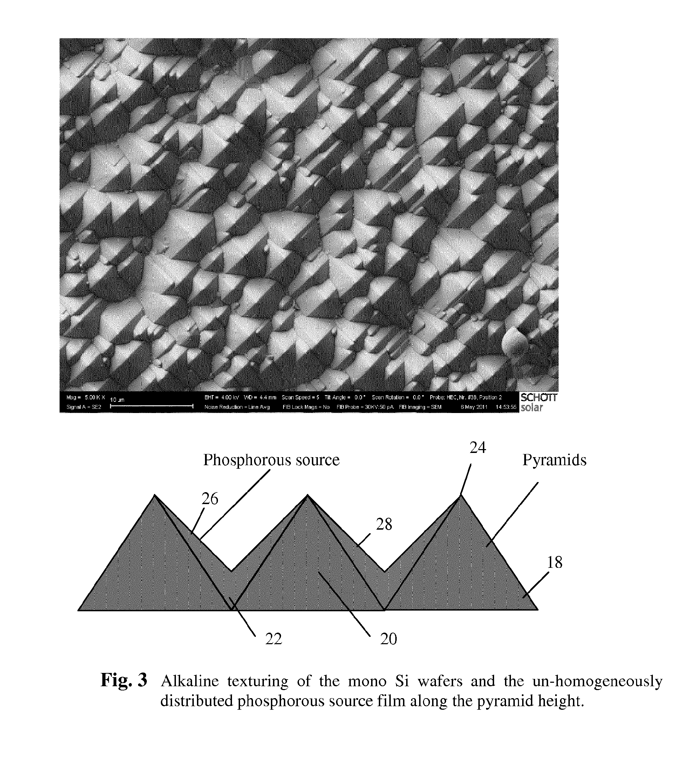

A totally different kind of texturing appears in case if mono-material is used. The texturing in an alkaline hot chemical solution permits to etch on the silicon surface real pyramids. It decreases considerable the reflection losses of the incident light from the cell surface. Typically alkaline etched pyramids 18, 20 are shown in Fig. 3.

The pyramid height depends on the texturing conditions and usually it varies in the range of 3-10 µm. In such a way the silicon surface is characterized by a presence of a specific "mountainous landscape" containing "valleys" 22 and "tips" 24. It was observed that after the deposition of the liquid phosphorous source the liquid 26, 28"flows" from the tips 24 of pyramids 18, 20 to the valleys 22 filling them. At the same time the thickness of the liquid source on the pyramid tips 24 is strongly reduced. P. Ferrada et al (Characterization of height-selective emitters, Silicon PV: 17-20 April 2011, Freiburg, Germany) has reported about the effect of un-homogeneous distribution of the liquid precursor on the alkaline textured Si surface.

Experiments done with alkaline textured wafers diffused by fast and slow drive-in methods, having a liquid phosphorous source, showed an increased contact resistance for the deep emitters. The decreased FF reduces the advantages of the slow drive-in method.

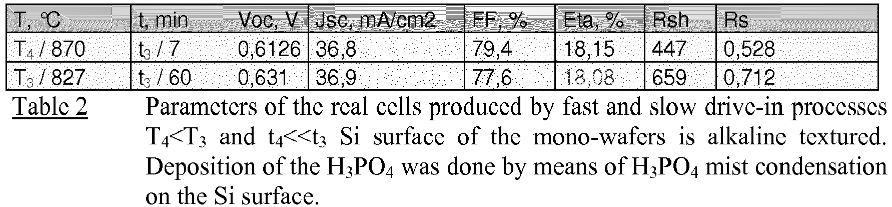

As it is shown in Table 2 the FF of the slowly diffused emitter is reduced in comparison to the fast diffused emitter. Despite of the fact that the deep emitter produces 10 mV more than a shallow one the ohmic losses reduce the cell efficiency and the effect of the long drive-in process has a negative impact on the efficiency. It is obviously clear that the FF losses have an ohmic nature. The measured series resistances Rs indicate an increased value of the deep emitter series resistance.

Due to the fact that the sheet resistance of the both emitters is equal, the texturing, metallization and antireflective coating processes were identical for both diffused groups and performed in the same run, it is possible to affirm that the ohmic losses of the FF in the slowly diffused emitter are caused by an increased contact resistance.

In order to get the maximal gain from the improved Voc of the deep emitter it is necessary to decrease the contact resistance between the front metallization and semiconductor.

A method for developing a dopant profile in a silicon wafer is known from DE-A-10 2010 079 321. Onto the wafer is applied a phosphor dopant source which is then dried in order to form a first dopant profile. Thereby precipitates are formed which are then removed for the purpose of performing a second temperature treatment step to form a desired dopant profile.

An object of the present invention is to develop the aforementioned method such that it is possible to set the dopant concentration in the surface region such that no contact problems occur when applying a front contact. Furthermore, it is aimed for a high efficiency of solar cells made of semiconductor substrates which are processed according to the invention.

For solving these objects, it is basically provided that the drying of the dopant source is followed by two temperature treatment steps, with the semiconductor substrate in a first temperature treatment step being heated up to a temperature T₁ and being held over a time t₁ at the temperature T₁ and being subsequently cooled down to a second temperature T₂, and in a second temperature treatment step being held over a time t₂ at the temperature T2; the temperature difference ΔT between T₁ and T₂ is 50 °C ≤ ΔT < 100°C and t₁ << t₂.

Thereby it is especially provided that the time t₁, during which the substrate is high-temperature treated, is to time t₂, during which the substrate is low-temperature treated, in the ratio of 1:3 to 1:10, i.e. t₂ is three to ten times larger than t₁.

It is further of adavantage, when T₁ does not exceed 950 °C and/or T₂ does not exceed 870 °C.

The high-temperature process has the effect that in the P-Si precipitates formed the phosphor atoms are activated, i.e. set free, with the consequence that the P-concentration in the surface region, i.e. directly in the region of the pyramids, is so high that the following second temperature treatment at low temperature over a relatively long period leads to the result that the surface concentration of the dopant decreases only to such an extent that no undesired contact resistance to the front contact to be produced can occur. On the other hand, sufficient P-atoms can diffuse simultaneously into the substrate to form an emitter. Furthermore, the dopant concentration in the surface region is not high enough to allow the occurrence of recombinations which affect negatively the degree of efficiency.

The temperature profile of the drive-in diffusion process according to the invention has a beneficial impact on the phosphorous concentration profile. By increasing slightly the phosphorous surface concentration of the emitter it decreases the contact resistance of the metal-semiconductor junction and it increases the fill factor and finally it improves the efficiency of the cell.

It is especially provided that in the first temperature treatment step the temperature T₁ is set between 850 °C and 900 °C and in the second temperature treatment step the temperature T₂ is set between 790 °C and 830 °C.

Exceedingly good results can be achieved with the semiconductor substrate being held during the first treatment step at the temperature T₁ over a time t₁ with 2 min ≤ t₁ ≤ 15 min and/or during the second treatment step at the temperature T₂ over a time t₂ with 30 min ≤ t₂ ≤ 120 min.

According to the invention, the surface concentration of the dopant, which results after the drying of the dopant source, is virtually preserved by activating the P-atoms of the P-Si precipitates.

In the following lower temperature step, the precipitates do not set free any P-atoms for a long period with the consequence that the dopant concentration in the front contact region is sufficient to avoid any contact problems when applying a front contact, while undesired recombinations leading to a loss of efficiency do not occur. Simultaneously, P-atoms diffuse into the semiconductor substrate to the required extent for producing a deep emitter.

Irrespectively of this, the total processing time in which the emitter is formed can remain unchanged compared to known methods. The processing costs are not increased. The throughput in the in-line process remains unchanged. Any additional complex machine is not necessary. Sole requirement is a temperature adjustment in order to form in the in-line process the desired dopant profile in the semiconductor substrate.

Further details, advantages and features of the invention ensue not only from the claims and the features to be taken from these - in themselves and/or in combination - but also from the following description of the preferred embodiment shown in the drawing.

Shown are in:
- Fig. 1: phosphor concentration profiles of solar cell emitters according to the state of the art,
- Fig. 2: temperature profiles for producing profiles according to Fig. 1 following the state of the art,
- Fig. 3: a schematic diagram and, in cut-out, a surface region of a pyramidal textured mono-crystalline silicon wafer,
- Fig. 4: temperature profiles to form a dopant profile in a pyramidal textured mono-crystalline silicon wafer according to the state of the art and to the teaching of the invention,
- Fig. 5: a temperature/ time profile,
- Fig. 6: a distribution of phosphorous concentration in semiconductor substrates according to both the state of the art and the invention, and
- Fig. 7: a distribution of phosphorous concentration after single diffusion steps.

In order to form an emitter in an alkaline textured mono-crystalline silicon semiconductor substrate (Fig. 3) with a dopant concentration in the surface region avoiding contact problems with front contacts, the invention provides the following treatment of corresponding silicon wafers using an in-line drive-in process.

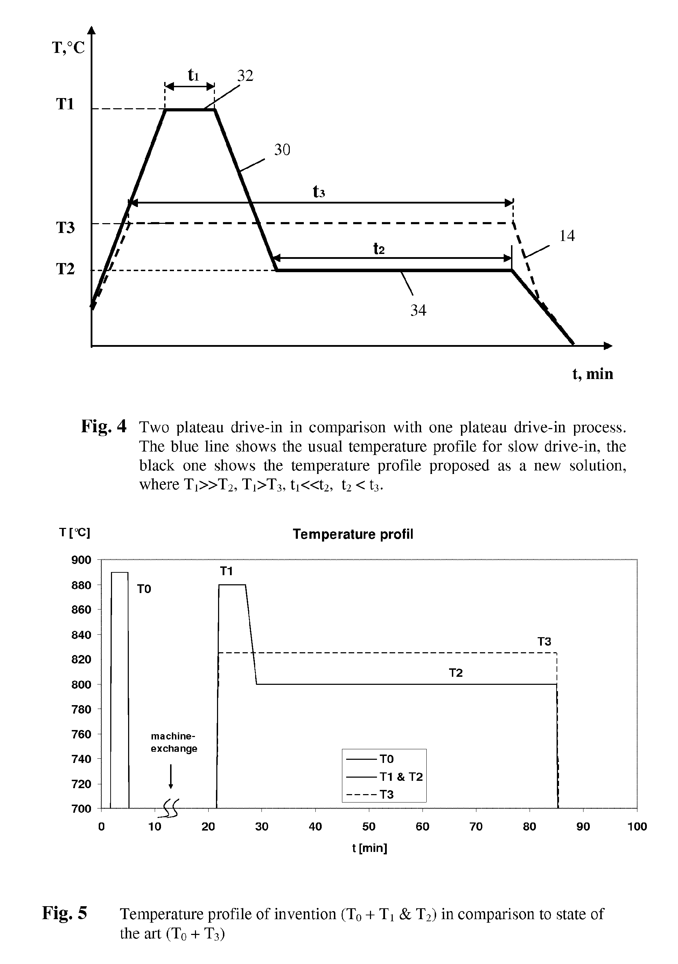

In a first step, a liquid dopant source in form of especially a phosphorus containing solution is applied onto the surface with the pyramidal structure (Fig. 3) and is then dried. Said drying step is carried out according to the state of the art, i.e. the phosphorus solution typically is dried for a period of 3 min to 5 min at a maximum temperature of 890 °C. Thereby, P-Si precipitates are generated at the surface of the silicon wafer while the surface is saturated with phosphor. The phosphor concentration is approx. 10²¹ phosphor atoms/cm³. During the following in-line drive-in or diffusion process, the wafer is subjected to two temperature treatment steps at different temperatures and for different periods. In a first temperature treatment step the wafer is heated up to a temperature T₁ in the range of 820 °C and 950 °C and is held at the temperature T₁ over a relatively short period t₁ between 2 min and 15 min. Then the wafer is cooled down to a temperature T₂ in the range of 750 °C and 870 °C where it is held over a time t₂ for 30 min to 120 min. Hence, a two plateau drive-in process is carried out as represented by curve 30 in Fig. 4. The first plateau 32 is at the temperature T₁ and the second plateau 34 at the temperature T₂. The periods are named t₁ and t₂ in Fig. 4. Furthermore, Fig. 4 shows a temperature profile which corresponds to the one shown in Fig. 2 and is marked correspondingly with reference number 14. The total time t₁ + t₂ thereby corresponds approximately to the process time t3 according to the state of the art.

After the second heat treatment step the P-concentration in vicinity of the front side surface, i.e. in the region of the pyramids, is about 5-8 x 10²⁰ P-atoms/cm³.

It is to be mentioned that the precipitates remain in the surface area during the first and second temperature treatment step, i.e. a removal by any further process step as a removal by etching does not take place.

That means the process cost is not increased, the throughput is not reduced, additional accessories are not needed. According to the invention the temperature profile is divided in two parts containing two temperatures plateaus:
1: High temperature plateau T₁ with short duration t₁;
2: Low temperature plateau T₂ with long duration t₂.

During the plateau (T1_{,} t₁), because of high temperature, the phosphorous atoms diffuse very fast in Si, the high temperature activates phosphorous atoms making them free from the P-Si precipitate. This is very important especially for the tip regions of the texture pyramids. Thickness of the phosphorous source is strongly reduced in these places and therefore, an additional amount of dopant is required there. This additional amount is delivered from the activated P atoms from the clusters. The requested emitter sheet resistance is obtained during this short step. Because of the fast diffusion the P-surface concentration is distributed near the silicon surface and a shallow emitter with an increased P surface concentration is produced (see Fig. 1). Then, the temperature T goes down to a low value of temperature T₂, where the diffusion coefficient of P at surface is too low to produce changes in the surface concentration profile and P-atoms remain captured at the surface in Si-P precipitate phase. At the same time the P-atoms in bulk of the emitter diffuse deeper increasing the emitter depth. The resulting P-concentration profile of combined plateaus (T₁, t₁) und (T₂, t₂) is a profile with slightly increased P-surface concentration in comparison to the "deep emitter" curve (see Fig. 1) and an increased depth of profile in comparison to "shallow emitter" curve. These emitter properties allow to reduce contact resistance and to minimize recombination current in the Emitter Space Charge Regions as well.

The P-concentration after the second temperature treatment is about 5 - 8 x 10²⁰ P-atoms/cm³_{.}

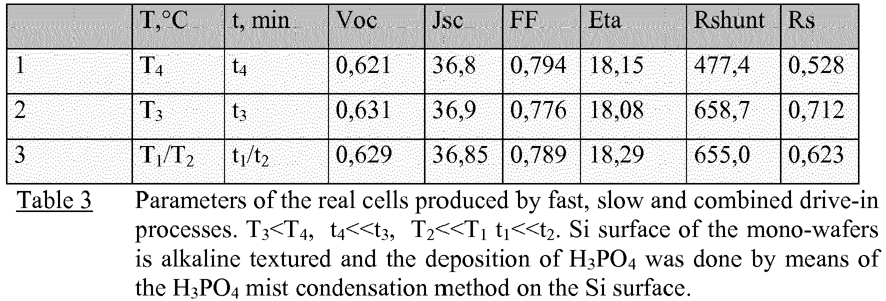

Table 3 shows the results of solar cells processed by means of the in-line drive-in process which have been treated according to the teaching of this invention (line 3), respectively to state of the art (line 1: short process time at temperatures according to curve 16 in Fig. 2 corresponding to curve 12 in Fig. 1; line 2: temperature treatment according to curve 14 in Fig. 2 corresponding to curve 10 in Fig. 1).

The results from Table 3 show the highest efficiency in case of two temperature plateaus drive-in solar cells. In spite of the fact that the drive-in durations for the cells from group 2 and 3 are equal, the ohmic losses in case of the group 3 are reduced. It has a positive effect on the total cell efficiency. The proposed temperature profile increases P-surface concentration solving the problem of the high contact resistance.

Range of the possible values of temperature and duration (see Fig. 4) is next:
T₁ varies between 850 - 900 °C,
T₂ varies between 790 - 830°C,
ΔT = T₁ - T₂ varies between 50 °C - 100 °C,
t₁ varies between 2 - 15 min,
t₂ varies between 30 - 120 min,
1:3 ≥ t₁:t₂ ≥ 1: 10.

The basic differences between the invention and the state of the art are explained by means of Figs. 5-7 and table 4.

**Table 4: Plateau phosphorous concentrations and emitter depths corresponding to the above described thermal steps**

| (--◊--) | **drying:** | | | | |
|---|---|---|---|---|---|
| | T(0) | t(0) plateau | plateau P concentration | plateau depth | emitter depth |
| | 890°C | 3 min | 3E+21 - 6E+21 at./cm³ | 10 nm | 100 nm |

| (--□--) | **activation & high Temperature drive in:** | | | | |
|---|---|---|---|---|---|
| | T(1) | t(1) plateau | plateau P concentration | plateau depth | emitter depth |
| | 880°C | 5 min | 2,5E+21 1,OE+21 at./cm³ | 20 nm | 300 nm |

| (--Δ--) | **low Tempemperature drive in:** | | | | |
|---|---|---|---|---|---|
| | T(2) | t(2) plateau | plateau P concentration | plateau depth | emitter depth |
| | 800°C | 55 min | 2,5E+21 - 1,0E+21 at./cm³ | 20 nm | 500 nm |

| (--○--) | **state of the art drive in (Horzel et.al.):** | | | | |
|---|---|---|---|---|---|
| | T(3) | t(3) plateau | plateau P concentration | plateau depth | emitter depth |
| | 825 °C | 60 min | 1E+21 - 8E+20 at./cm³ | 10 nm | 530 nm |

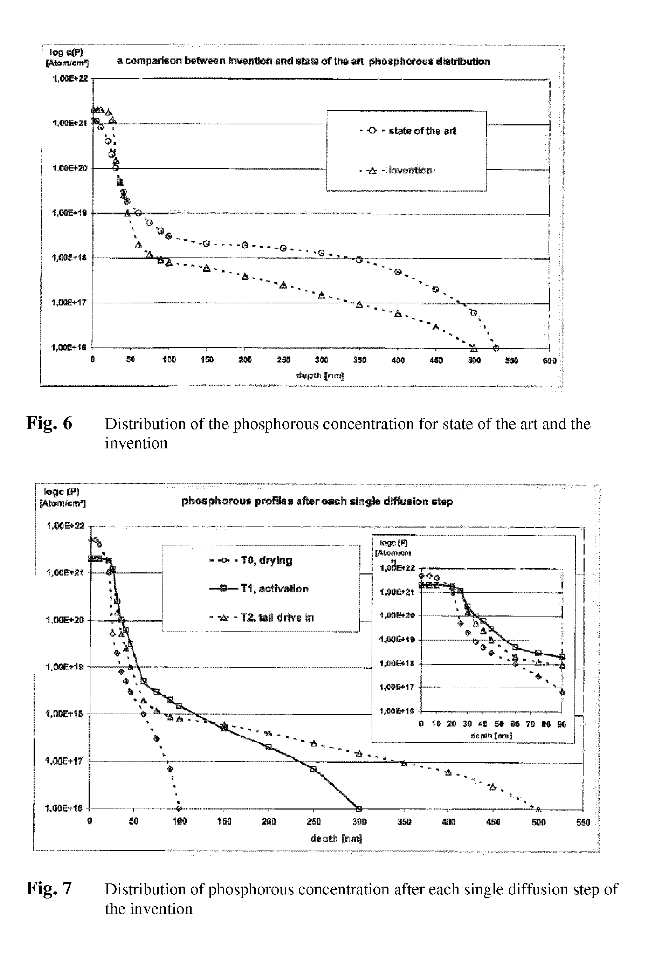

Comparison tests were carried out with substrates being treated according to the state of the arte and to the teaching of the present invention. Insofar, time/ temperature profiles have been used as shown in Fig. 5. The respective times and temperatures can also be learned from Table 4. Table 4 discloses the temperatures along with the times chosen for each treatment step. According to both the state of the art and the teaching of the present invention a drying step is performed in the first place for drying the dopant applied to the substrate. In tests, the substrates were subjected for 3 min to a temperature of 890 °C. Subsequently, a concentration in the range of 3 x 10²¹ to 6 x 10²¹ phosphor atoms/ cm³ could have been determined in the surface region. This is also shown in Figs. 6 and 7. Said concentration extends over a layer thickness of 10 nm starting from the substrate surface. During this application, an emitter is formed up to a depth of 100 nm.

This is also shown in Fig. 7 representing the distribution of the phosphor concentration after each diffusion step according to the invention. But since the state of the art provides also a drying step, the course of concentration results as represented in the curve by the squares standing on their tip.

If a dopant profile is formed according to the prior art, as disclosed for instance in WO-A-2010/066626, then the substrate is subjected for 60 min to a temperature of 825 °C (T₃) corresponding to Table 4 and Fig. 5.

In a surface layer of a thickness of 10 nm a phosphor concentration between 1 x 10²¹ to 8 x 10²¹ phosphor atoms/ cm³ exists. As shown in Fig. 6, the emitter extends up to a depth of approx. 530 nm.

When carrying out the drive-in process according to the invention, the substrate is subjected at first for 5 min (t₁) to a temperature T₁ of 880 °C. This results in a dopant profile as shown in Fig. 7 by the curve with the squares. A plateau region results, i.e. a surface layer region where the phosphor concentration remains almost constant. The depth of this region is 20 nm starting from the surface. The concentration is in the range of 2,5 x 10²¹ to 1 x 10²¹ phosphor atoms/ cm³. The emitter depth is 300 nm as shown in Fig. 7.

Next, the second temperature step is carried out at a temperature T₂ with 800 °C over a time t₂ with t₂ = 55 min. In the surface region, the phosphor concentration is stable since due to the lower temperature compared to temperature T₁ an activation of phosphor atoms from the surface layer is no longer possible.

The fact that the phosphor concentration remains steady after the first and second temperature step according to the invention is also made obvious by the cutout in Fig. 7.

Fig. 6 shows once more the phosphor concentration profiles which can be achieved according to the state of the art, respectively according to the invention. It can be seen that thanks to the teaching of the invention a high phosphor concentration is given in the surface region so that no problems arise during contacting.

## Claims

1. Method for producing a dopant profile in an alkaline textured mono-crystalline silicon based semiconductor substrate of a solar cell, comprising:
• applying a liquid dopant source onto the textured surface of the semiconductor substrate,
• drying the dopant source while precipitates are generated simultaneously,
• performing at least one heat treatment step for diffusing dopant atoms into the semiconductor substrate,
**characterized in**
**that** the drying of the dopant source is followed by two temperature treatment steps of the semiconductor substrate with the precipitates in its pyramidal surface area, with the semiconductor substrate in a first temperature treatment step being heated to a temperature T1 and being held over a time t1 at the temperature T1 and being subsequently cooled down to a second temperature T2, and in a second temperature treatment step being held over a time t2 at the temperature T2, the temperature difference ΔT between T1 and T2 being 50 °C ≤ ΔT ≤ 100 °C and t1 << t2.

2. The method according to claim 1,
**characterized in**
**that** a phosphorus containing solution is used as liquid dopant source.

3. The method according to claim 1 or 2,
**characterized in**
**that** the liquid dopant source is dried for a period between 3 min and 5 min at a maximum temperature of 890 °C.

4. The method according to at least one of the preceding claims, **characterized in**
**that** in the first temperature treatment process the semiconductor substrate is subjected to the temperature T1 with 820 °C ≤ T1 ≤ 950 °C.

5. The method according to at least one of the preceding claims, **characterized in**
**that** in the second temperature treatment process the semiconductor substrate is subjected to the temperature T2 with 750 °C ≤ T2 ≤ 870 °C.

6. The method according to at least one of the preceding claims, **characterized in**
**that** during the first temperature treatment process the semiconductor substrate is held at the temperature T1 over a time t1 with 2 min ≤ t1 ≤ 15 min.

7. The method according to at least one of the preceding claims, **characterized in**
**that** during the second temperature treatment process the semiconductor substrate is held at the temperature T2 over a time t2 with 30 min ≤ t2 ≤ 120 min.

8. The method according to at least one of the preceding claims, **characterized in**
**that** the time t1 is set to the time t1 as 1:10 ≤ t1:t2 ≤ 1:3.
